# EUROPEAN PATENT APPLICATION

(11) **EP 2 302 988 A2**
(43) Date of publication of application: **30.03.2011**
(21) Application number: 10181202.2
(22) Date of filing: 28.09.2010
(51) Int. Cl.: H05K 3/34

(54) **Method of soldering an electronic component**

(30) Priority: 29.09.2009 JP 2009224660
(71) Applicant: FUJITSU LIMITED, Kawasaki-shi, Kanagawa 211-8588 (JP)
(72) Inventor: Koyama, Fumigi, Kawasaki-shi Kanagawa 211-8588 (JP); Higashi, Osamu, Kawasaki-shi Kanagawa 211-8588 (JP)
(74) Representative: Fenlon, Christine Lesley

(57) **Abstract**

A soldering method of an electronic component includes inserting pins of the electronic component into through-holes provided in a printed circuit board; preheating interiors of the through-holes with an inert fluid; and bonding the pins to the through-holes by exposing molten solder to the preheated through-holes.

## Description

### FIELD

The embodiments discussed herein relate to a method of soldering an electronic component.

### BACKGROUND

A pin-type electronic component, such as a connector and a large-capacitance capacitor, is mounted on a printed circuit board in such a manner that pins of the electronic component are inserted into and soldered to through-holes of the printed circuit board. On the other hand, a chip-type electronic component does not require through-holes when mounted on the printed circuit board.

There is a known method of soldering a chip-type electronic component onto a printed circuit board called reflow soldering in which the chip-type electronic component is placed on solder paste applied on the printed circuit board and the solder paste is then melted by heating (see for example Japanese Patent No. 3974525 or Japanese Laid-open Patent Application No. 2007-208176). On the other hand, flow soldering method is known, which soldering pins of a pin-type electronic component into through-holes provided in a printed circuit board in which the back surface of the printed circuit board opposite the surface having the electronic component is dipped in molten solder contained in a solder bath (see for example Japanese Laid-open Patent Application No. 5-92259).

In the flow soldering method, if the back surface of the printed circuit board is dipped in the molten solder for an unnecessarily long time, an increased amount of copper may be eluted from the inner walls of the through-holes and through-hole pads provided at the through-holes into the molten solder, damaging the inner walls of the through-holes and the through-hole pads.

First, a soldering method according to a first comparative example will be described.

In the soldering method according to the first comparative example, soldering of pins of a component into through-holes of a printed circuit board is performed by simply dipping a region of the printed circuit board having the through-holes into which the pins have been inserted in molten solder contained in a solder bath.

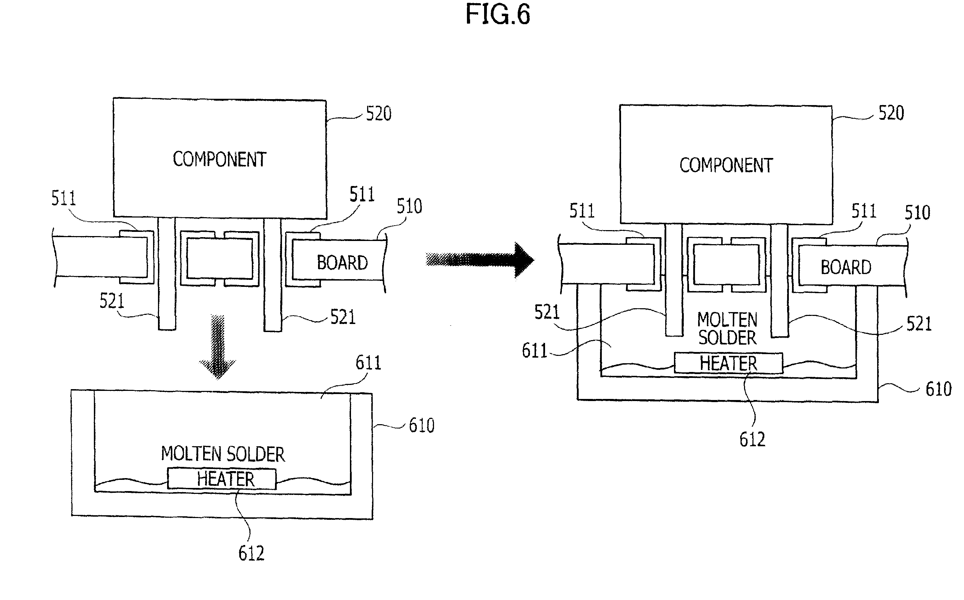

Fig. 6 illustrates the soldering method according to the first comparative example.

In the soldering method according to the first comparative example shown in Fig. 6, soldering is performed by simply dipping a region of a printed circuit board 510 having through-holes 511 into which pins 521 of a component 520 have been inserted in molten solder 611 contained in a solder bath 610. The molten solder 611 is melted by a heater 612 provided in the solder bath 610.

In such a soldering method, it is preferable that the region of the printed circuit board having the through-holes be dipped in the molten solder for a shorter time. If the region of the printed circuit board having the through-holes is dipped in the molten solder for an unnecessarily long time, copper may be eluted from the inner walls of the through-holes and through-hole pads provided at the through-holes into the molten solder, damaging the inner walls and the through-hole pads.

In such a soldering method, it is preferable that the region of the printed circuit board having the through-holes be dipped in the molten solder for a shorter time. If the region of the printed circuit board having the through-holes is dipped in the molten solder for an unnecessarily long time, copper may be eluted from the inner walls of the through-holes and through-hole pads provided at the through-holes into the molten solder, damaging the inner walls and the through-hole pads.

Next, a soldering method according to a second comparative example obtained by adding to the soldering method according to the first comparative example a technique that minimizes the difficulty in short-time soldering due to the slow rise of temperature inside the through-holes will be described.

The soldering method according to the second comparative example differs from the soldering method according to the first comparative example in that soldering is performed by dipping the region of a printed circuit board having through-holes in a solder bath while feeding hot air toward a component on the printed circuit board from above. The second comparative example will now be described, focusing on the difference from the first comparative example.

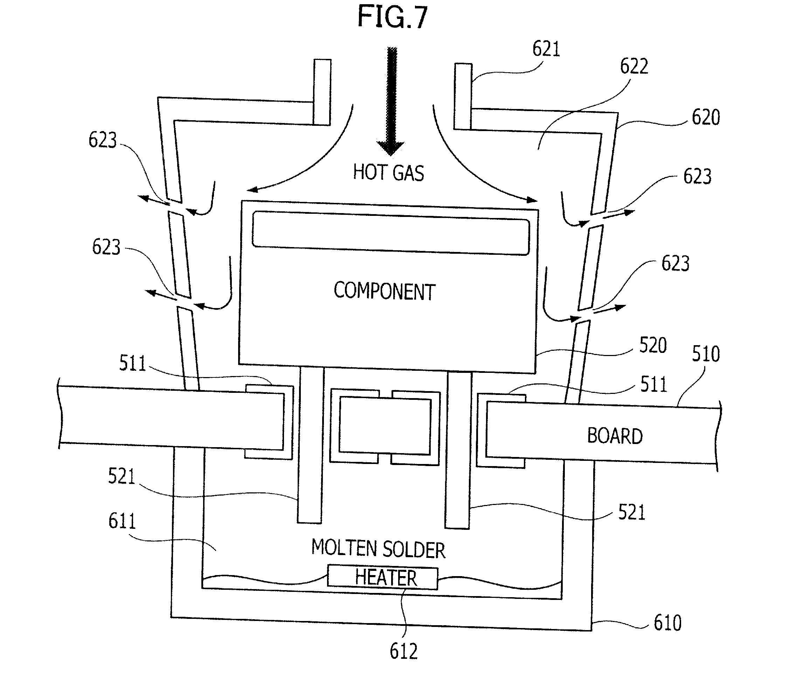

Fig. 7 illustrates the soldering method according to the second comparative example.

In Fig. 7, elements the same as those shown in Fig. 6 are denoted by reference numerals the same as those in Fig. 6, and redundant descriptions thereof are omitted.

In the second comparative example, when soldering is performed, a cover 620 is placed over the top surface of the mounting region of the printed circuit board 510 having the component 520. The cover 620 is provided with a gas supply port 621 at a position thereof above the component 520. When soldering is performed, hot air 622 is supplied through the supply port 621. The hot air 622 is fed from above toward the component 520 and is exhausted from a plurality of exhaust ports 623 provided in sidewalls of the cover 620.

In the soldering method according to the second comparative example, since the surfaces of the component 520 and the printed circuit board 510 are heated with the hot air 622, the temperature inside the through-holes 511 rises quicker than in the soldering method according to the first comparative example. Nevertheless, in the soldering method according to the second comparative example, it is difficult to introduce a sufficient amount of hot air 622 into the through-holes 511 that are behind the body of the component 520 and are substantially stopped by the pins 521. Therefore, in most cases in the second comparative example, the original temperature of the hot air 622 is set to a high level so that the temperature inside the through-holes 511 may be raised to a sufficiently high level even with such an insufficient amount of hot air 622. If, however, the temperature of the hot air 622 is too high, the component 520 directly receiving the hot air 622 may be heated beyond the temperature that the component 520 may resist. Consequently, the component 520 may be damaged.

Because of factors such as increases in the density of components 520 mounted on the printed circuit board 510 and in the number of wires provided in the printed circuit board 510 in recent years, the number of layers included in the printed circuit board 510 has been increasing. Accordingly, the thickness of the printed circuit board 510 has also been increasing. To cause the molten solder 611 to sufficiently spread into the through-holes 511 in the soldering method according to the first comparative example, the temperature inside the through-holes 511 may be raised to above the melting point of the solder. In the soldering method according to the first comparative example, the interiors of the through-holes 511 are heated with the heat from the molten solder 611. Therefore, if the printed circuit board 510 is thick as described above, it takes a long time for the heat to be sufficiently transferred over the entirety of the through-holes 511, making it difficult to complete soldering in a short time. Moreover, depending on the type of the component 520, the lengths of the pins 521 may be too short to protrude from the through-holes 511. In such a case, it takes more time for the heat to be transferred to the interiors of the through-holes 511, making it more difficult to complete soldering in a short time. If the printed circuit board 510 is thicker than 2 mm, the through-holes 511 may extend through four or more layers including solid pattern layers such as a power-source layer and a grounding layer. Since such solid pattern layers draw much heat from the through-holes 511, the difficulty in completing soldering in a short time is increased.

In addition, due to environmental considerations in recent years, the use of lead-free solder, such as Sn-Ag-Cu (SAC) solder, has been promoted. The lead-free solder has a higher melting point than the solder containing lead, such as Sn-Pb eutectic solder. The SAC solder has a melting point 30°C or more higher than that of the Sn-Pb eutectic solder. In a case where the lead-free solder is used, before the temperature inside the through-holes 511 is raised to a level required for sufficient spreading of the molten solder 611, the component 520 may be adversely affected in terms of heat resistance and the like. This also increases the difficulty in completing soldering in a short time.

### SUMMARY

According to an aspect of an embodiment, a soldering method of an electronic component includes inserting pins of the electronic component into through-holes provided in a printed circuit board; preheating interiors of the through-holes with an inert fluid; and bonding the pins to the through-holes by exposing molten solder to the preheated through-holes.

The present invention is defined in the attached independent claim. Further, preferred features can be found in the subsidiary claims appended thereto.

It is to be understood that both the foregoing general description and the following detailed description are exemplary and explanatory and are not restrictive of the invention, as claimed.

### BRIEF DESCRIPTION OF DRAWINGS

Fig. 1 is a flowchart showing an example of an embodiment of a soldering method;

Fig. 2 schematically illustrates a preheating step shown in Fig. 1;

Fig. 3 schematically illustrates a bath-replacing step shown in Fig. 1;

Fig. 4 schematically illustrates how molten solder spreads into through-holes;

Fig. 5 schematically illustrates a discharging step and a board-removing step shown in Fig. 1;

Fig. 6 illustrates a soldering method according to a first comparative example from the Related Art; and

Fig. 7 illustrates a soldering method according to a second comparative example from the Related Art.

### DESCRIPTION OF EMBODIMENTS

Specific embodiments of the soldering method according to the basic embodiment described above will now be described with reference to the accompanying drawings.

In the figures, dimensions and/or proportions may be exaggerated for clarity of illustration. It will also be understood that when an element is referred to as being "connected to" another element, it may be directly connected or indirectly connected, i.e., intervening elements may also be present. Further, it will be understood that when an element is referred to as being "between" two elements, it may be the only element layer between the two elements, or one or more intervening elements may also be present.

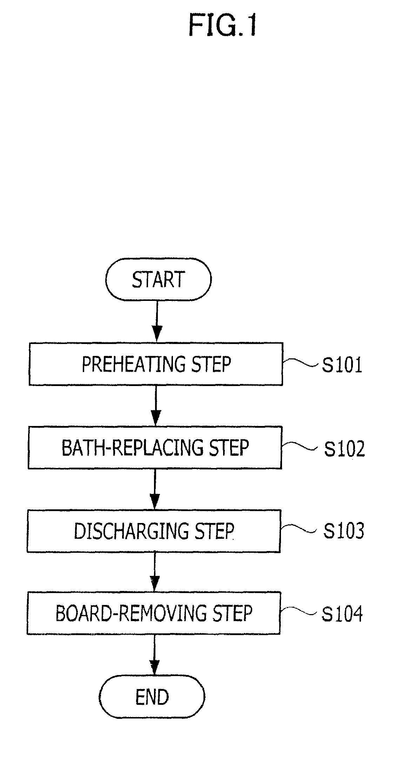

Fig. 1 is a flowchart showing an example of an embodiment of the soldering method.

In a soldering method shown by the flowchart in Fig. 1, soldering is performed after the interiors of through-holes into which pins of a component have been inserted is preheated to a specific preheating temperature. The soldering method includes a preheating step (Step S101), a bath-replacing step (Step S102), a discharging step (Step S103), and a board-removing step (Step S104).

The individual steps of the soldering method shown by the flowchart in Fig. 1 will now be described in detail.

In the preheating step (Step S101) of Fig. 1,

after pins of a pin-type electronic component are inserted into through-holes of a printed circuit board, the preheating step is performed as described below.

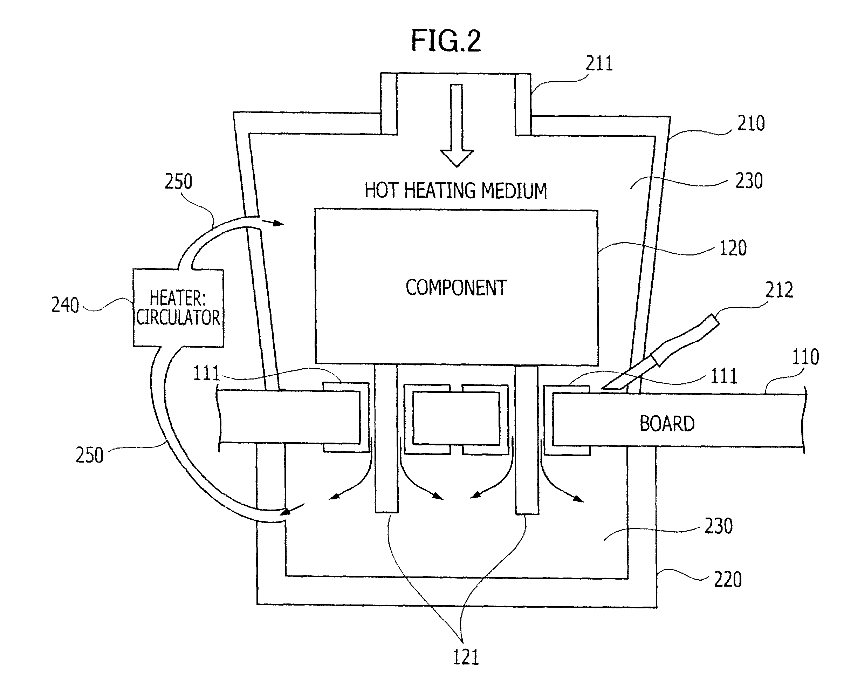

Fig. 2 schematically illustrates the preheating step shown in Fig. 1.

In Fig. 2, through-holes 111 of a printed circuit board 110 and pins 121 of an electronic component 120 are schematically shown in an enlarged scale.

In the preheating step, a first medium bath 210 is placed over the electronic component 120 mounted on the top surface of the printed circuit board 110, and a second medium bath 220 is placed over the back surface of the printed circuit board 110. The two medium baths 210 and 220 are filled with a heating medium 230 described below.

The heating medium 230 is an electrically insulating, stable (inert) fluid (solvent), and is resistant to corrosion and/or deterioration with respect to the solder and the printed circuit board 110.

The heating medium 230 may be an inert fluid having good electrical-insulation having a dielectric permittivity in the range of 2.0 to 3.0 and heat-transfer characteristics in the range of 0.05 to 0.1 W/m°C, and is not limited to a specific type. The heating medium 230 used in the present embodiment is, for example, a fluorine-containing oil such as perfluoropolyether (PEPE) oil, chlorotrifluoroethylene (CTFE) oil, or fluorocarbon-based fluid. If PEPE oil is used, Galden® (a registered trademark of Solvay Solexis) HT200 or HT270 having a boiling point of 270°C may be used. In use of Gafden® as a heating medium, the dielectric permittivity may be 2.1, and the heat-transfer characteristic may be 0.07 W/m°C.

The first medium bath 210 is provided at a position thereof above the electronic component 120 with a supply port 211 through which the heating medium 230 is supplied. The supply port 211 is not limited to be in the first medium bath 210 and may be provided in the second medium bath 220. The first medium bath 210 is also provided in a sidewall thereof with a discharge port 212 through which the heating medium 230 is discharged in the discharging step described below. The discharge port 212 is closed during the preheating step. The discharge port 212 is not limited to be in the sidewall of the first medium bath 210.

The present embodiment employs a fluid circulator 240 described below. The two medium baths 210 and 220 communicate with each other through a circulation pipe 250 guiding the heating medium 230 from the second medium bath 220 to the first medium bath 210. The fluid circulator 240 circulates the heating medium 230 along a circulation path starting from the second medium bath 220 through the circulation pipe 250 to the first medium bath 210 and returning from the first medium bath 210 through the through-holes 111 to the second medium bath 220. The fluid circulator 240 includes a heater. In the present embodiment, the heating medium 230 that is being circulated is heated by the heater while flowing through the circulation pipe 250.

In the present embodiment, the preheating step is performed as follows, for example.

First, one end of the circulation pipe 250 is attached to the second medium bath 220.

Subsequently, the second medium bath 220 is filled with the heating medium 230 that is preheated to a preheating temperature of 150 to 180°C, which is lower than the above-mentioned boiling point, in such a manner that the heating medium 230 does not flow out of the other end of the circulation pipe 250. The preheating temperature to which the heating medium 230 is preheated corresponds to a preheating temperature suitable for soldering to be performed later. The preheating temperature to which the heating medium 230 is preheated is sufficiently lower than the maximum temperature that the electronic component 120 can resist.

Subsequently, the printed circuit board 110 is placed over the second medium bath 220 in such a manner that the back surface of a mounting region of the printed circuit board 110 having the electronic component 120 touches the heating medium 230 in the second medium bath 220, and then the first medium bath 210, which is empty, is placed over the mounting region having the electronic component 120.

Subsequently, the other end of the circulation pipe 250 is attached to the first medium bath 210. Thus, the first medium bath 210 and the second medium bath 220 are made to communicate with each other through the circulation pipe 250 guiding the heating medium 230.

Subsequently, the heating medium 230 that is preheated to the above preheating temperature is supplied into the first medium bath 210 through the supply port 211. After the first medium bath 210 is filled with the heating medium 230, the supply port 211 is closed.

Since the heating medium 230 supplied into the first medium bath 210 is fluid, the heating medium 230 spreads into the through-holes 111 that are behind the body of the electronic component 120 and are substantially stopped by the pins 121 under gravity and by capillary action. Consequently, the interiors of the through-holes 111 are exposed to the heating medium 230 having a temperature of 150 to 180°C.

Subsequently, the heating medium 230 that has spread as described above is circulated by the fluid circulator 240 along the circulation path. During the circulation, the temperature of the heating medium 230 that is being circulated is maintained at the preheating temperature with the heat from the heater. Because of the circulation, the interiors of the through-holes 111 continue to be exposed to the heating medium 230 having the preheating temperature of 150 to 180°C.

The interiors of the through-holes 111 are exposed to the heating medium 230 for a preheating time described below.

In the present embodiment, how long the through-holes 111 are to be exposed to the heating medium 230 before the temperature inside reaches the preheating temperature is determined in advance using samples. In the present embodiment, the mounting region having the electronic component 120 is exposed to the heating medium 230 for the preheating time determined in advance, whereby the temperature inside the through-holes 111 is raised to the preheating temperature.

Next, the bath-replacing step (Step S102) shown in Fig. 1 will be described.

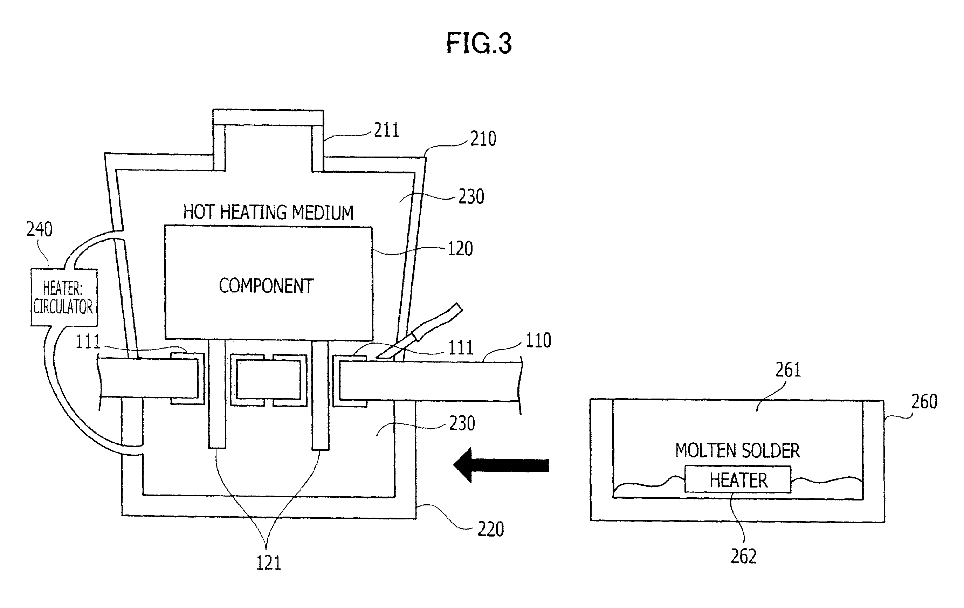

Fig. 3 schematically illustrates the bath-replacing step shown in Fig. 1.

In the present embodiment, the bath-replacing step is performed as follows, for example.

First, after the fluid circulator 240 is stopped and the circulation of the heating medium 230 is thus stopped, the circulation pipe 250 connecting the fluid circulator 240 and the two medium baths 210 and 220 is detached. Subsequently, the second medium bath 220 is retracted away from the mounting region of the printed circuit board 110 having the electronic component 120. In this state, because of factors including that of the supply port 211 of the first medium bath 210 being closed and that of the through-holes 111 being substantially stopped by the pins 121, incidences of the heating medium 230 leaking from the through-holes 111 are reduced or prevented.

Subsequently, a solder bath 260 filled with molten solder 261 is placed below the mounting region. Located within the solder bath 260, is a heater 262 that heats solder to its melting point or higher, whereby the solder is maintained in a melted state. In the present embodiment, the molten solder 261 is lead-free, for example.

By the bath-replacing step, a region of the printed circuit board 110 having the through-holes 111 and the pins 121 that are to be soldered to each other are dipped in the molten solder 261 that is maintained in a melted state in the solder bath 260 as described above. In this state, the molten solder 261 spreads into the through-holes 111.

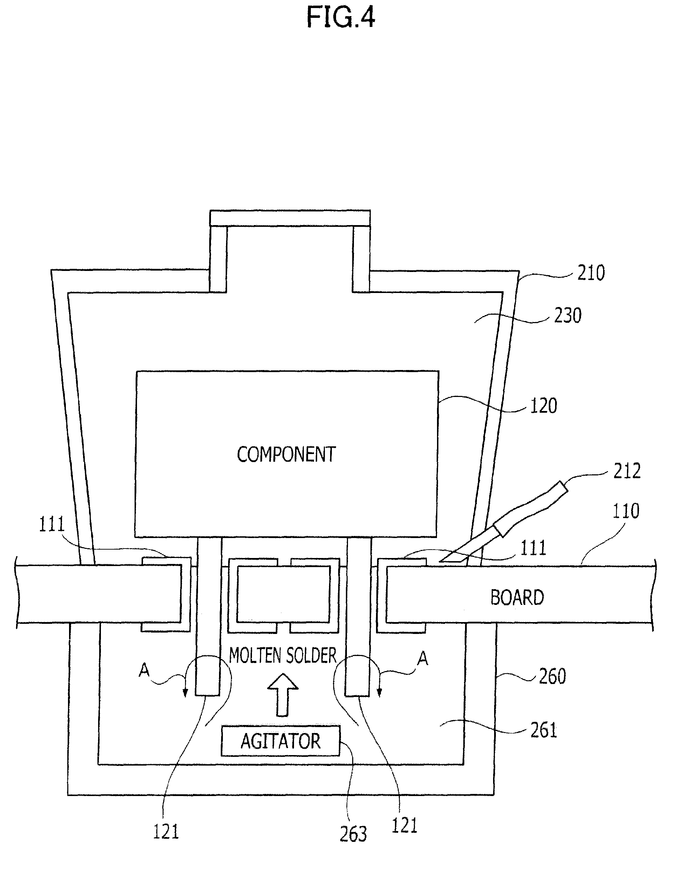

Fig. 4 schematically illustrates how the molten solder 261 spreads into the through-holes 111.

The through-holes 111 and the pins 121 that have been preheated as described above are further heated by the molten solder 261 to a temperature higher than or substantially equal to the melting point of the solder. The molten solder 261 in a wet state moves upward into the through-holes 111 that have been heated to a high temperature. Thus, the molten solder 261 spreads in the through-holes 111. Here, since the through-holes 111 and the pins 121 are preheated, the heating with the molten solder 261 performed thereon is completed in a short time.

In the present embodiment, as shown in Fig. 4, the molten solder 261 spreads in a state where the top surface of the mounting region of the printed circuit board 110 having the electronic component 120 is covered by the first medium bath 210 filled with the heating medium 230. Therefore, the temperature of the through-holes 111 and the pins 121 that have been preheated is substantially prevented from being lowered. Since the mounting region is kept covered by the first medium bath 210 as described above, the molten solder 261 in the wet state moves upward in the through-holes 111 that are filled with the heating medium 230. Here, the temperature of the molten solder 261 is higher than the boiling point of the heating medium 230. Therefore, when the molten solder 261 spreading upward touches the heating medium 230 in the through-holes 111, the heating medium 230 is volatized. Thus, the heating medium 230 is removed from the through-holes 111.

In the present embodiment, the solder bath 260 also has inside an agitator 263 that agitates the molten solder 261 upward from the bottom of the solder bath 260 as indicated by arrows A. The agitator 263 produces upward flows of the molten solder 261 near the center of the solder bath 260. With the upward flows, the molten solder 261 is forcibly fed toward the through-holes 111. Consequently, the molten solder 261 easily spreads into the through-holes 111.

Next, the discharging step (Step S103) and the board-removing step (Step S104) shown in Fig. 1 will be described.

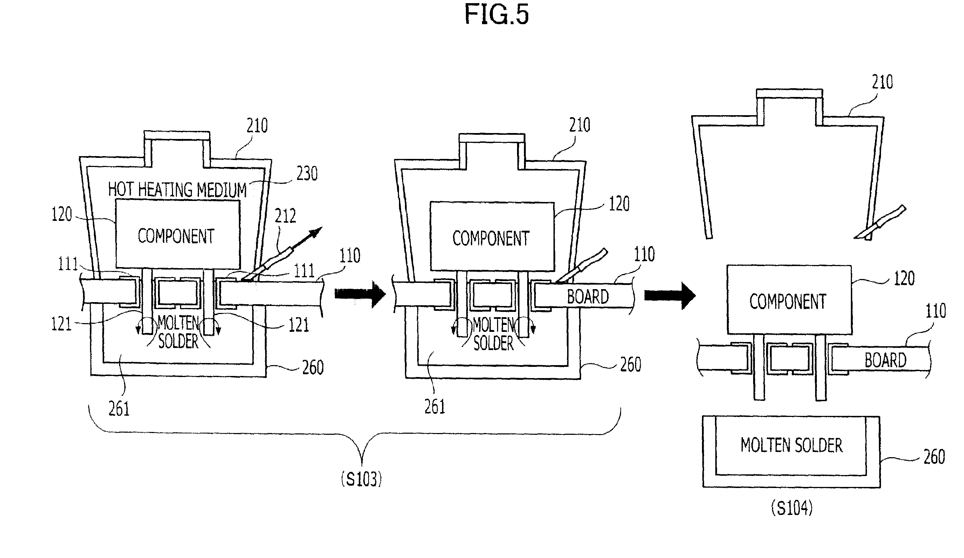

Fig. 5 schematically illustrates the discharging step and the board-removing step shown in Fig. 1.

In the present embodiment, the two steps are performed as follows, for example.

In the discharging step (Step S103), the temperature of the heating medium 230 is first lowered from the preheating temperature to about the normal temperature. Subsequently, the discharge port 212 is opened and the heating medium 230 is discharged to the outside of the first medium bath 210. In the present embodiment, the lowering of the temperature of the heating medium 230 in the discharging step (Step S103) provides safety and contributes to the hardening of the molten solder 261 in the through-holes 111.

Furthermore, in the discharging step (Step S103), the upward flows of the molten solder 261 are continuously produced in the solder bath 260. Since the temperature of the heating medium 230 is lowered, incidences of unnecessary solder adhesion to the back surface around the through-holes 111 and to the pins 121 are reduced or prevented.

After the discharging step (Step S103), the board-removing step (Step S104) is performed. In the board-removing step (Step S104), the first medium bath 210 is removed from the printed circuit board 110, and the printed circuit board 110 that have undergone soldering is removed from the solder bath 260. With the removal of the two baths 210 and 260, the hardening of the molten solder 261 in the through-holes 111 is further promoted.

As described above with reference to Fig. 5, in the present embodiment, the temperature of the heating medium 230 is first lowered, the heating medium 230 is then discharged from the first medium bath 210, and the printed circuit board 110 that has undergone soldering is subsequently removed. That is, in the present embodiment, the provision of safety and the hardening of the molten solder 261 in the through-holes 111 are performed substantially simultaneous, and the printed circuit board 110 that has undergone soldering is subsequently removed.

Through the two steps described with reference to Fig. 5, the soldering according to the present embodiment ends. If there are any other components to be mounted by soldering of pins thereof into other through-holes, the process shown by the flowchart in Fig. 1 is repeated for the number of mounting regions for those components.

In contrast to the soldering methods according to the comparative examples of Related Art Figs. 6-7, in the embodiment described with reference to Figs. 1 to 5, soldering is performed after the interiors of the through-holes 111 are preheated with the heating medium 230 in a fluid state. Therefore, when soldering is performed, the time required for raising the temperature inside the through-holes 111 to a level higher than the melting point of the solder is shortened by the preheating time with the use of the heating medium 230. Furthermore, the preheating is performed by dipping the printed circuit board 110 in the heating medium 230 in a fluid state. Hence, the heating medium 230 easily spreads into a space below the electronic component 120 and into the through-holes 111 under gravity and by capillary action. Therefore, the heat of the heating medium 230 is easily transferred to the interiors of the through-holes 111. Consequently, in the soldering method according to the above embodiment, the pins 121 of the electronic component 120 are soldered to the through-holes 111 in a short time and in a good manner.

In the soldering method according to the embodiment, the heat of the heating medium 230 is easily transferred to the interiors of the through-holes 111 as described above. Therefore, even if the temperature of the heating medium 230 is set to a little low level, the interiors of the through-holes 111 is preheated to a sufficient level. Consequently, the temperature of the heating medium 230 can be set to be lower than the temperature that the electronic component 120 can resist, whereby prevention of damage on the electronic component 120 and performance of short-time soldering are realized simultaneously.

In the soldering method according to the above embodiment, as shown in Fig. 2, the supply port 211 through which the heating medium 230 is supplied is provided in the first medium bath 210, covering the top surface of the mounting region of the printed circuit board 110 having the electronic component 120, at a position above the electronic component 120. Therefore, in the preheating step, the heating medium 230 is supplied through the supply port 211 in a direction in which the electronic component 120 is pressed against the printed circuit board 110. Consequently, the printed circuit board 110 is dipped in the heating medium 230 while the electronic component 120 is substantially prevented from, for example, unintentionally floating during the preheating step.

That is, in the present embodiment, a first modification is preferable in which the first fluid bath has a supply port through which the fluid is supplied at a position thereof higher than the mounting region.

In the soldering method according to the embodiment, preheating is performed while the heating medium 230 is circulated between the two medium baths 210 and 220 by the fluid circulator 240 along the circulation path including the through-holes 111. Thus, the heating medium 230 is actively introduced into the through-holes 111. Consequently, the interiors of the through-holes 111 are preheated efficiently.

That is, in the present embodiment, an example of a second modification in which the preheating step may include a communicating sub-step and a circulating sub-step, the communicating sub-step being a step of making the first fluid bath and the second fluid bath communicate with each other through a fluid passage guiding the fluid, the circulating sub-step being a step of circulating the fluid along a circulation path connecting the first fluid bath, the second fluid bath, and the through-holes.

As described with reference to Fig. 2, the circulation of the heating medium 230 is performed while the heating medium 230 that is being circulated is heated by the heater provided in the fluid circulator 240. Thus, the temperature of the heating medium 230 in the two medium baths 210 and 220 is substantially prevented from being lowered. Consequently, the interiors of the through-holes 111 are assuredly preheated.

That is, in the second modification in which the preheating step includes the communicating sub-step and the circulating sub-step, a further modification is preferable in which the circulating sub-step is a step of heating the fluid being circulated along the circulation path to the preheating temperature at any position on the circulation path.

In the soldering method according to the embodiment, as shown in Fig. 4, upward flows of the molten solder 261 are produced near the center of the solder bath 260 while soldering is performed. With such upward flows, the molten solder 261 is forcibly fed toward the through-holes 111, as described above. Consequently, the molten solder 261 easily spreads into the through-holes 111.

That is, in the present embodiment, an example of a third modification in which upward flows of the molten solder toward the printed circuit board may be produced in the solder bath.

In the embodiment, the provision of safety and the hardening of the molten solder 261 in the through-holes 111 are performed simultaneously, and the printed circuit board 110 that has undergone soldering is subsequently removed, as described above. The embodiment provides an efficient method because the provision of safety and the hardening of the molten solder 261 are performed simultaneously when the printed circuit board 110 that has undergone soldering is removed.

That is, in the present embodiment, an example of a fourth modification in which the hardening step may be performed such that the temperature of the fluid in the first fluid bath is first lowered in a state where the back surface of the mounting region is dipped in the molten solder in the solder bath, the fluid is then discharged from the first fluid bath, and the solder bath and the first fluid bath are subsequently removed from the printed circuit board.

The specific embodiment of the soldering method according to the basic embodiment concerns a case where pins of a single component are soldered into through-holes. The soldering method according to the basic embodiment, however, is not limited to such a case and may be applied to another case where pins of a plurality of components are soldered into through-holes. In that case, corresponding adjustments to the method would in cluding using medium baths and a solder bath having wide openings that cover all of mounting regions for those components.

All examples and conditional language recited herein are intended for pedagogical objects to aid the reader in understanding the invention and the concepts contributed by the inventor to furthering the art, and are to be construed as being without limitation to such specifically recited examples and conditions. Although the embodiment(s) of the present inventions have been described in detail, it should be understood that the various changes, substitutions, and alterations could be made hereto without departing from the scope of the invention.

## Claims

1. A method of soldering an electronic component comprising:
inserting pins of the electronic component into through-holes provided in a printed circuit board;
preheating interiors of the through-holes with an inert fluid; and
bonding the pins to the through-holes by exposing the through-holes to molten solder.

2. The method according to Claim 1, further comprising placing a first fluid bath and a second fluid bath containing the inert fluid over both surfaces of the printed circuit board,
wherein the preheating further includes circulating the inert fluid between the first fluid bath and the second fluid bath.

3. The method according to Claim 2, wherein the first and second fluid baths communicate through a passage that guides the inert fluid.

4. The method according to Claim 3, wherein the inert fluid is heated by a heater provided in the passage.

5. The method according to Claim 2, wherein the second fluid bath is placed over a surface of the printed circuit board where an end of the inserted pins is projected with respect to the printed circuit board.

6. The method according to Claim 5, further comprising replacing the second fluid bath with a solder bath containing the molten solder when a temperature inside the through-holes reaches a specified temperature.

7. The method according to Claim 6, further comprising retaining heat of the through-holes with the first fluid bath during said exposing the through-holes to molten solder.

8. The method according to Claim 1, wherein the inert fluid is a dielectric.

9. The method according to Claim 8, wherein the dielectric has a permittivity in the range of 2.0 to 3.0.

10. The method according to Claim 1, wherein the inert fluid is a thermal conductor.

11. The method according to Claim 10, wherein the thermal conductor has a thermal conductivity in the range of 0.05 to 0.1 W/m°C.
